Europäisches Patentamt

European Patent Office

Office européen des brevets

(11) Publication number: **0 063 479**
**B1**

# EUROPEAN PATENT SPECIFICATION

(45) Date of publication of patent specification: **10.07.85**

(21) Application number: **82301951.8**

(22) Date of filing: **15.04.82**

(51) Int. Cl.⁴: **H 03 F 1/04,** H 03 C 1/16, H 03 F 3/22

(54) An amplifier for pulse width modulated signals.

(30) Priority: **22.04.81 GB 8112444**

(43) Date of publication of application:
**27.10.82 Bulletin 82/43**

(45) Publication of the grant of the patent:
**10.07.85 Bulletin 85/28**

(84) Designated Contracting States:
**CH DE FR LI NL**

(56) References cited:
**GB-A-1 566 095**
**US-A-3 258 710**
**US-A-4 160 945**

(73) Proprietor: **THE MARCONI COMPANY LIMITED**
**Marconi House New Street**
**Chelmsford Essex CM1 1PL (GB)**

(72) Inventor: **Molyneux-Berry, Robert Bewes**
**12, Hopping Jacks Lane**
**Danbury Essex (GB)**
Inventor: **Fitz, Philip John**
**5, Hollywood Close**
**Great Baddow Chelmsford Essex (GB)**

(74) Representative: **Tolfree, Roger Keith**
**Marconi House New Street**
**Chelmsford, CM1 1PL (GB)**

Courier Press, Leamington Spa, England.

## Description

This invention relates to an amplifier for pulse width modulated signals.

One such amplifier is described in our U.K. Patent Specification 1566095 which relates to a technique for applying a substantially constant current to the control grid of a valve during pulses of the signal to be amplified so as to switch the valve on during those periods, the resulting anode currents on the valve being an amplified version of the signal to be amplified. This technique differs from conventional amplifiers for pulse width modulated signals in which the voltage of the control grid (rather than the current to it) is held at a fixed level during each pulse.

The constant current sources described in the aforementioned U.K. Patent Specification 1566095 consist of batteries connected in series with inductors. Whilst this is perfectly satisfactory for some purposes, the inductors must necessarily be of inconveniently large size if high fidelity amplification of low frequency modulation signals is to be ensured. Such large inductors generally have considerable stray capacitance. The repeated charging and discharging of this capacitance by the pulse signals to be amplified distorts the edges of the latter, possibly to a serious degree causing power loss and distortion of the modulating signal.

This invention provides an amplifier for pulse width modulated signals comprising a constant current source including an inductor for supplying a relatively small electric current; a first switch having a control electrode and being adapted to conduct a relatively large electric current in response to receipt by its control electrode of the said small electric current; and a second switch for switching the said small electric current to the control electrode in response to a pulse of the signal to be amplified; characterised in that the constant current source comprises a current sensor for sensing current through the inductor and a third switch controlled by the current sensor to control the current through the inductor.

Since the current to the control electrode is controlled by the current sensor and the said third switch, the inductor does not need to be as large as might otherwise be necessary. It is therefore possible, by employing the invention, to reduce the severity of the problem previously mentioned in relation to the amplifier described in Specification 1566095.

Whilst the invention is applicable to pulse width modulation amplifiers in which the first switch is a solid state device, it will normally be a tetrode valve. In that event the control electrode is constituted by a first grid of the valve, the second grid (often referred to as the "screen") preferably being provided with a second constant current source. The second constant current source preferably comprises a second inductor, a second current sensor for sensing currents through the second inductor and a fourth switch controlled by the second current sensor to prevent the currents through the second inductor from exceeding a desired value.

Where a tetrode valve as described above is used, it is preferable that means be provided for closing the third and fourth switches for periods occurring at the same frequency, the durations of such periods being controlled by the current sensors. This avoids the generation of undesired audio frequencies which might result from the mixing of two different switching frequencies. It is convenient to close the third and fourth switches at a constant frequency dependant on the pulse repetition frequency of the signal to be amplified.

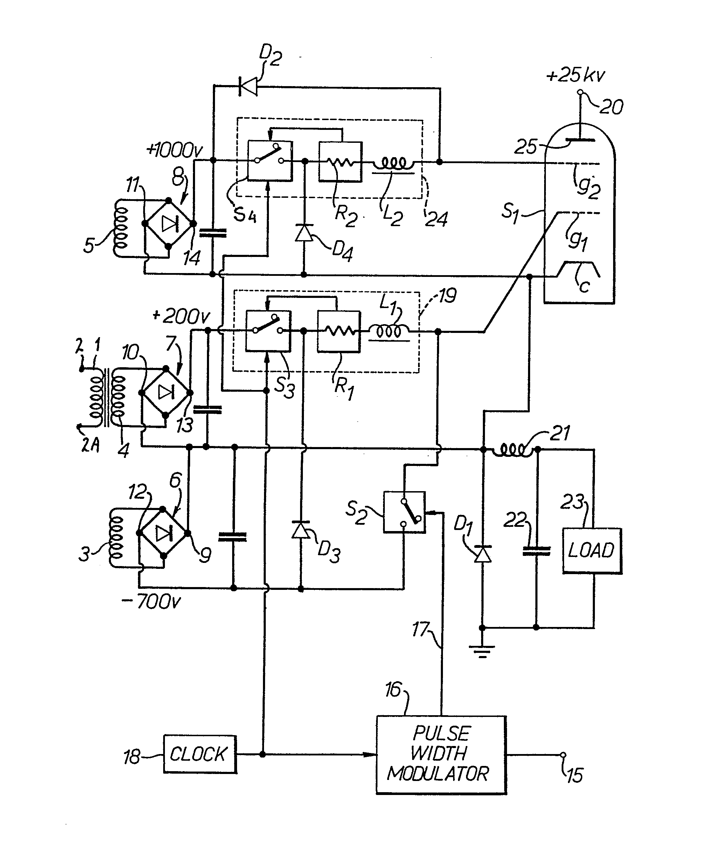

An amplifier for pulse width modulated signals employing the invention will now be described for the purposes of example with reference to the accompanying drawing.

Referring to the drawing there are shown three power supplies having a common transformer primary 1 to which an A.C. mains supply is connected at terminals 2 and 2A. The transformer has three secondary windings 3, 4 and 5 which are connected to respective diode rectifiers indicated schematically at 6, 7 and 8 respectively. Output terminals 9, 10 and 11 of respective rectifiers 6, 7 and 8 are connected together and assume a reference voltage close to earth. An output terminal 12 of the rectifier 6 acquires a voltage of $-700$ volts, an output terminal 13 of the rectifier 7 acquires a voltage of $+200$ volts and an output terminal 14 of the rectifier 8 acquires a voltage of $+1000$ volts. It will be appreciated, of course, that these figures are given only as an example and that other voltages could be used providing that the voltage at 9 is below the reference voltage, the voltage at 13 is above the reference voltage, and the voltage at 14 is above the voltage at 13.

This particular embodiment of the invention is designed to amplify amplitude modulated audio signals which are applied at an input terminal 15 and are converted into pulse width modulated signals by a pulse width modulator 16 whose output at 17 consists of a series of pulses at regular intervals determined by a clock 18, each pulse lasting for a period proportional to the amplitude of the signal at 15. Such pulse width modulators are well known. Each pulse from the modulator 16 turns on a first switch $S_1$, which is constituted by a tetrode valve, for the duration of that pulse and most of the illustrated circuitry, which will now be described, is involved with performing this function of turning on the switch $S_1$.

During the periods between pulses of the signal at 17 a switch $S_2$ is closed and current from a constant current source 19 passes to the $-700$ volt terminal 12 so that a first control grid $G_1$ of the tetrode valve $S_1$ is maintained at $-700$ volts. This ensures that the tetrode is switched off. During the pulses of the signal at 17 the switch $S_2$ is open circuited which causes the current from constant current source 19 to charge the grid $G_1$ to a positive potential, thereby switching on the

tetrode $S_1$ and allowing a large current to pass from a 25Kv source 20 through an inductor 21 to charge a capacitor 22. The inductor 21 and capacitor 22 act as a low pass filter serving to pass to a load 23 only frequencies lower than the pulse repetition frequency determined by the clock 18 (typically 50 to 100 Khz). The voltage across the capacitor 22 and a load 23 therefore follows the input audio signal at 15 but at a much amplified level. Whilst the valve $S_1$ is non-conductive the current in $L_2$ is drawn through a diode $D_2$.

When the tetrode $S_1$ is switched on by the opening of switch $S_2$ a second grid $G_2$ (hereinafter termed the "screen") is able to pass a current supplied by a second constant current source 24 and assumes a positive voltage somewhat lower than that of the 1000 volt terminal 14. A diode $D_2$ allows the current from the constant current source 24 to circulate when the tetrode valve is switched off.

In the illustrated pulse width modulated signal amplifier the relative potentials of the anode 25, the grid $G_1$ and the screen $G_2$ with respect to the cathode C adjust themselves in accordance with the valve characteristics since it is the current to the grid and screen which are controlled in contrast to the normal practice with tetrode valves of controlling the voltages of the grid and screen. An advantage of controlling the currents to the grid and screen is that the valve may be rendered fully conductive without the currents drawn (by grid and screen) ever exceeding the particular values necessary for the valve to conduct the crest modulation current with low on-resistance. When the valve is rendered conductive, but with little or no modulation being present, the screen and grid potentials tend to fall with respect to the cathode C so that the dissipation at the screen and grid is diminished thus remaining at a safe level under all conditions of modulation. If conventional voltage control of the valve electrodes were employed the screen and grid currents would tend to rise when little or no modulation were present, causing over dissipation of these electrodes. Since the illustrated system consumes no power above the minimum required to render the valve conducting at the modulation level for the time being present high efficiency can be achieved. The constant current source 19 comprises a first inductor $L_1$ connected in series with a resistive current sensor $R_1$ and a third switch $S_3$. The switch $S_3$ is closed by each clock signal from the clock 18 and remains closed until the sensor $R_1$ determines that the current in inductor $L_1$ has risen to a predetermined level, this level being defined by a setting of the sensor $R_1$. The sensor $R_1$ then opens the switch $S_3$. The mark to space ratio of the switch $S_3$ is thus automatically adjusted to produce the required constant current through the inductor $L_1$, the latter being sufficiently large not to pass the switching frequency of the switch $S_3$. When the switch $S_3$ is open, current through the inductor $L_1$ is drawn through a diode $D_3$.

The constant current source 24 may be similar to the constant current source 19 and employs an inductor $L_2$, resistive current sensor $R_2$ and switch $S_4$, the latter also being closed by each clock signal from the clock 18 and opened by a signal from the current sensor $R_2$ (the setting of which may be different from $R_1$). A further diode $D_4$ serves a purpose similar to the diode $D_3$.

The fact that both switches $S_3$ and $S_4$ operate at the same switching frequency determined by the clock 18 eliminates the possibility of audio frequency harmonics arising as might occur if two different switching frequencies were used.

**Claims**

1. An amplifier for pulse width modulated signals comprising a constant current source (19) including an inductor ($L_1$) for supplying a relatively small electric current; a first switch ($S_1$) having a control electrode ($g_1$) and being adapted to conduct a relatively large electric current in response to receipt by its control electrode ($g_1$) of the said small electric current; and a second switch ($S_2$) for switching the said small electric current to the control electrode ($g_1$) in response to a pulse of the signal to be amplified; characterised in that the constant current source (19) comprises a current sensor ($R_1$) for sensing current through the inductor ($L_1$) and a third switch ($S_3$) controlled by the current sensor ($R_1$) to control the current through the inductor ($L_1$).

2. An amplifier according to claim 1 in which the first switch ($S_1$) is a thermionic valve, the said control electrode ($g_1$) is a first grid and the valve has a second grid ($g_2$) having a second constant current source (24), the latter comprising a second inductor ($L_2$), a second current sensor ($R_2$) for sensing current through the second inductor ($L_2$) and a fourth switch ($S_4$) controlled by the second current sensor ($R_2$) to control the current through the second inductor ($L_2$).

3. An amplifier according to claim 2 comprising means (18) for closing the third switch ($S_3$) at instants occurring at a set frequency and maintaining it closed for periods, whose duration varies under the control of the first current sensor ($R_1$); and means (18) for closing the fourth switch ($S_4$) at instants occurring also at a said frequency and maintaining it closed for periods whose duration varies under the control of the second current sensor ($R_2$); the set frequencies for the third and fourth switches ($S_3$, $S_4$) being the same.

4. An amplifier according to claim 3 in which the frequency of closing of the third and fourth switches ($S_3$, $S_4$) is synchronous with the frequency of the pulse width modulated signal.

5. An amplifier according to any preceding claim in which the or each constant current source (19, 24) is connected to a rectifier (7, 8) for rectifying an alternating current and supplying a direct current to the or each inductor ($L_1$, $L_2$).

**Patentansprüche**

1. Ein Verstärker für durch Pulsbreite modulierte Signale, bestehend aus einer Konstantstromquelle (19) mit einem Induktor ($L_1$) zum Liefern eines relativ kleinen elektrischen Stroms; einem ersten Schalter ($S_1$) mit einer Steuerelektrode ($g_1$), eingerichtet zum Führen eines relativ hohen elektrischen Stroms durch Ansprechen auf den Empfang an seiner Steuerelektrode ($g_1$) des besagten kleinen elektrischen Stroms; und einem zweiten Schalter ($S_2$) zum Schalten des besagten kleinen elektrischen Stroms an die Steuerelektrode ($g_1$) durch Ansprechen auf einen Puls des zu verstärkenden Signals; dadurch gekennzeichnet, daß die Konstantstromquelle (19) aus einem Stromfühler ($R_1$) besteht, zum Erfassen des durch den Induktor ($L_1$) fließenden Stroms und einem dritten Schalter ($S_3$), welcher durch den Stromfühler ($R_1$) gesteuert wird, um den durch den Induktor ($L_1$) fließenden Strom zu steuern.

2. Ein Verstärker nach Anspruch 1, in dem der erste Schalter ($S_1$) aus einer Elektronenröhre besteht, wobei die besagte Steuerelektrode ($g_1$) ein erstes Gitter ist und die Röhre mit einem zweiten Gitter ($g_2$) versehen ist, welches eine zweite konstante Stromquelle (24) aufweist, wobei die letztere aus einem zweiten Induktor ($L_2$), einem zweiten Stromfühler ($R_2$) zum Erfassen des durch den zweiten Induktor ($L_2$) fließenden Stroms und einem vierten Schalter ($S_4$) besteht, welcher durch den zweiten Stromfühler ($R_2$) gesteuert wird, um den durch den zweiten Induktor ($L_2$) fließenden Strom zu steuern.

3. Ein Verstärker nach Anspruch 2, bestehend aus Einrichtungen (18) zum Schließen des dritten Schalters ($S_3$) zu Zeitpunkten, die mit einer vorbestimmten Häufigkeit auftreten, und diesen Schalter über Perioden geschlossen halten, deren Dauer durch Steuerung seitens des ersten Stromfühlers ($R_1$) veränderlich ist, sowie Einrichtungen (18) zum Schließen des vierten Schalters ($S_4$) zu Zeitpunkten, welche auch mit einer besagten Häufigkeit auftreten und diesen Schalter für Perioden geschlossen halten, deren Dauer durch Steuerung des zweiten Stromfühlers ($R_2$) veränderlich ist; wobei die Sollfrequenzen für den dritten und vierten Schalter ($S_3$, $S_4$) die gleichen sind.

4. Ein Verstärker nach Anspruch 3, bei dem die Häufigkeit, mit der der dritte und vierte Schalter ($S_3$, $S_4$) geschlossen wird, synchron mit der Frequenz des durch Pulsbreiten modulierten Signals ist.

5. Ein Verstärker entsprechend einem der vorhergehenden Ansprüche, in welchem die oder jede Konstantstromquelle (19, 24) an einen Gleichrichter (7, 8) angeschlossen ist, um einen Wechselstrom gleichzurichten und einen Gleichstrom an den oder jeden Induktor ($L_1$, $L_2$) anzulegen.

**Revendications**

1. Un amplificateur de signaux modulés par des impulsions à largeur variable comprenant une source de courant constant (19) avec une bobine d'induction ($L_1$) pour fournir un courant électrique relativement faible; comprend en outre un premier commutateur ($S_1$) ayant une électrode de commande ($g_1$) et adaptée pour conduire un courant électrique relativement important en réponse au dit faible courant qu'il reçoit par son électrode de commande ($g_1$); un second commutateur ($S_2$) pour commuter lesdits faibles courants électriques sur l'électrode de commande ($g_1$) en réponse à une impulsion du signal à amplifier; est caractérisé par le fait que la source de courant constant (19) comprend un capteur de courant ($R_1$) pour détecter le courant dans la bobine d'induction ($L_1$) et un troisième commutateur ($S_3$) commandé par le capteur de courant ($R_1$) pour commander le courant dans la bobine d'induction ($L_1$).

2. Un amplificateur répondant à l'objectif 1 dans lequel le premier commutateur ($S_1$) est un tube thermionique, ladite électrode de commande ($g_1$) constitue une première grille et le tube possède une seconde grille ($g_2$) ayant une seconde source de courant constant (24); cette source comprend une seconde bobine d'induction ($L_2$), un second capteur de courant ($R_2$) pour détecter le courant débitant dans la seconde bobine d'induction ($L_2$) et un quatrième commutateur ($S_4$) commandé par la seconde source de courant constant ($R_2$) pour commander le courant passant dans la seconde bobine d'induction ($L_2$).

3. Un amplificateur répondant à l'objectif 2 comprenant un dispositif (18) pour fermer le troisième commutateur ($S_3$) à des instants précis se produisant à une fréquence déterminée et le maintenant fermé pendant une certaine période dont la durée varie suivant la commande du premier capteur de courant ($R_1$); et un dispositif (18) pour fermer le quatrième commutateur ($S_4$) à des instants précis se produisant également à ladite fréquence et le maintenant fermé pendant des périodes dont la durée varie sous la commande du second capteur de courant ($R_2$); les fréquences déterminées pour les troisième et quatrième commutateurs ($S_3$, $S_4$) étant les mêmes.

4. Un amplificateur répondant à l'objectif 3 dans lequel la fréquence de fermeture des troisième et quatrième commutateurs ($S_3$, $S_4$) est synchrone avec la fréquence du signal modulé par des impulsions à largeur variable.

5. Un amplificateur répondant à tous les objectifs spécifiés auparavant dans lequel la ou chaque source de courant constant (19, 24) est raccordée à un redresseur (7, 8) pour redresser un courant alternatif et fournir un courant continu à la ou à chaque bobine d'induction ($L_1$, $L_2$).